# EUROPEAN PATENT APPLICATION

(11) **EP 1 464 969 A1**
(43) Date of publication of application: **06.10.2004**
(21) Application number: 03100902.0
(22) Date of filing: 04.04.2003
(51) Int. Cl.: G01R 31/30, G01R 31/316, G01R 31/3183, G01R 29/26, H03M 9/00

(54) **Loop-back testing with delay elements**

(71) Applicant: Agilent Technologies Inc, Palo Alto, CA 94303-0870 (US)
(72) Inventor: Rosenkraenzer, Alfred, 71034, Boeblingen (DE); Rottacker, Markus, 71034, Boeblingen (DE); Behrens, Klaus-Peter, 71034, Boeblingen (DE)
(74) Representative: Barth, Daniel

(57) **Abstract**

A coupling unit is coupled between a first and a second unit to be tested, and comprises one or more signal paths, each adapted to provide a signal connection between an output of the first unit to be tested and an input of the second unit to be tested. At least one of the one or more signal paths comprises a delay unit adapted to provide a delay for a signal traveling on the signal path.

## Description

### BACKGROUND OF THE INVENTION

Loop-back testing has been applied in various fields in particular for testing electronic devices. Typically, an output of a device to be tested is coupled to an input of that device, thus allowing testing performance of one or both the output and the input when applying adequate test signals. Instead of testing only one device, multiple devices interconnected with each other can be tested accordingly.

### SUMMARY OF THE INVENTION

It is an object of the present invention to provide an improved loop-back testing. The object is solved by the independent claims. Preferred embodiments are shown by the dependent claims.

The coupling unit according to the present invention allows an improved testing, in particular loop-back testing, by introducing delay into signals traveling between the first and second units to be tested. By applying such delay only to some of the signal paths or different delay to different signal paths, signals can be delayed with respect to each other, thus allowing testing e.g. susceptibility of the units to be tested with respect to time margins of the signals. In particular in case that variable delay units are applied, such time margins (such as e.g. setup and hold times in digital signals) can be varied, for example, for verifying minimum time margins e.g. as specified for the units to be tested.

Further, varying the delay over the time also allows to introduce jitter, thus rendering the possibility to evaluate susceptibility or sensibi lity with respect to jitter of the units to be tested. Applying different functions of the time relationship for the delay (such as e.g. sinusoidal, rectangular, triangular or other type of waveforms) allows to test various types of jitter signals or emulate different sources of jitter injection.

While the coupling unit of the present invention is preferably applied for loop-back testing between input(s) and output(s) of different functional units of the same device (e.g. between serializing and deserializing units or vice versa), it goes without saying that the coupling unit can also be applied for testing different devices physically separated from each other.

Any type of delay unit can be applied for the purpose of the present invention, and the applied delay unit(s) may be all of the same type but also different types can be applied for different delay units. Preferably, delay unit(s) as disclosed in US-A-6,127,871 by the same applicant can be used.

In one embodiment, a delay unit as disclosed in pending US application 10/273950 (by the same applicant) is used. Such delay unit can be applied for providing an output signal delayed by a delay time with respect to a periodic signal received at its input, such as a clock signal. The delay unit comprises a first delay cell to receive the periodic signal and to provide as output a first delayed signal corresponding to the input periodic signal but delayed by a variable first delay time. A selection unit receives the first delayed signal and a second signal derived from the periodic signal. A control unit controls the selection unit in order to select one of the first delayed signal and the second signal as the output signal of the delay unit, and further controls the first delay time of the first delay cell.

The first and second units to be tested are preferably electronic devices, e.g. integrated or discrete circuits, but may also be other types of devices such as optical devices, etc. Further in case of electronic devices, such devices are preferably digital devices, but may as well be analog or mixed devices.

The invention can be partly or entirely embodied or supported by one or more suitable software programs, which can be stored on or otherwise provided by any kind of data carrier, and which might be executed in or by any suitable data processing unit.

### BRIEF DESCRIPTION OF THE DRAWINGS

Other objects and many of the attendant advantages of the present invention will be readily appreciated and become better understood by reference to the following detailed description when considering in connection with the accompanied drawing(s). Features that are substantially or functionally equal or similar will be referred to with the same reference sign(s).

Fig. 1 shows an embodiment according to the present invention.

Fig. 2 illustrates an example for an application of the present invention.

Fig. 3 shows an embodiment for testing differential signals.

### MORE DETAILED DESCRIPTION OF PREFERRED EMBODIMENTS ACCORDING TO THE INVENTION

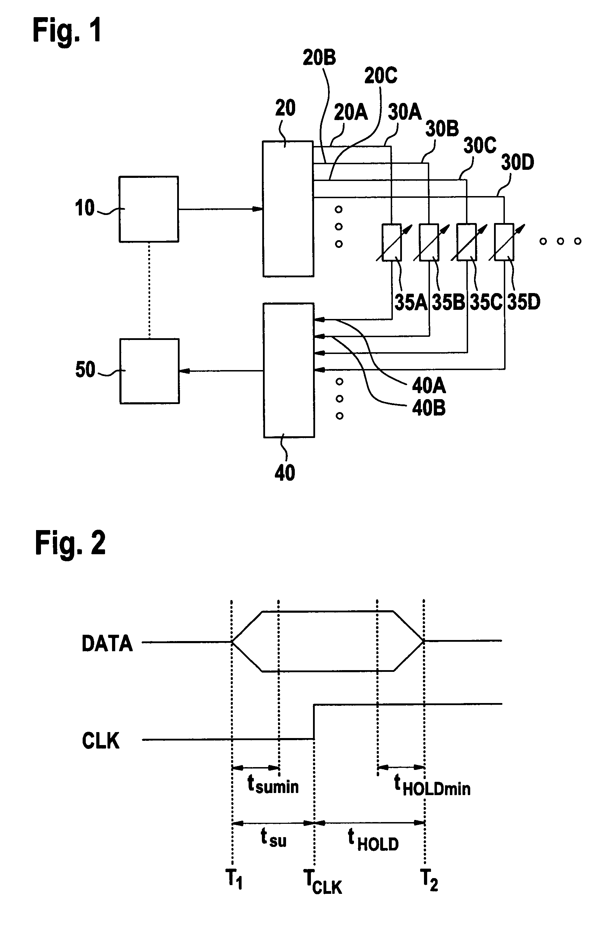

In Fig. 1, a signal source 10 provides a stimulus signal to an input of a first unit to be tested 20. In the example of Fig. 1, the unit 20 is a deserializer, deserializing a signal received at its input to a plurality of its outputs.

The outputs of the unit 20 are coupled via signal paths 30A, 30B, 30C, etc. with corresponding inputs of a second unit to be tested 40. In the example of Fig. 1, the unit 40 shall be a serializer for serializing the signal received at its input and providing the serialized signal at its output. Devices such as serializer and deserializer are well known in the art and need not to be detailed herein.

The output of the unit 40 is provided to a signal analysis unit 50. The signal analysis unit 50 analyzes the received signals, preferably by comparing the received response signals with expected response signals expected to receive in response to the applied stimulus signals. Such expected response signals might be derived from the signal source 10, as indicated by the dotted line, but can also be already stored in the analysis unit 50.

At least one of the signal paths 30 comprises a delay unit 35 for delaying signals traveling on the signal path 30. In the example of Fig. 1 each signal path 30i comprises a respective delay unit 35i (with i = A, B, C, ...). The plurality of signal paths 30 together with their respective delay lines 35 represent a coupling unit 60 for coupling between the units 20 and 40.

An application for testing the first and second units 20 and 40, e.g. as of Figure 1, shall now be illustrated with respect to Figure 2. The upper part in Figure 2 shows a data signal DATA, which becomes valid at a point in time T₁ and remains valid until a point in time T₂. A clock signal CLK in the lower part of Figure 2 has a rising edge at a point in time T_{CLK}·

The time difference between T_{CLK} and T₁ is usually referred to as setup time tₛᵤ, representing the time wherein the data signal DATA is valid until the clock signal CLK appears. Accordingly, the time between T₂ and T_{CLK} is usually referred to as hold time t_{HOLD}, representing the time after the clock signal CLK appears and the data signal DATA is still valid. Typically, each device to be tested has a specified minimum setup time t_{SUmin} and a minimum hold time t_{HOLDmin} as specified for example by the manufacturer of the device. Such specified minimum setup time t_{SUmin} and minimum hold time t_{HOLDmin} represent the specified minimum requirements for the application of valid signals, so that failure free operation of the device cab be specified.

Using the example of Figure 1, the output 20A of the unit 20 shall provide the clock signal CLK to the input 40A of the unit 40. Accordingly, the output 20B of the unit 20 shall provide the data signal DATA to the input 40B of the unit 40. For the sake of simplicity, only one such data signal shall be regarded here, however, it goes without saying that multiple such data signals can also be transmitted between the units 20 and 40.

Varying the point in time T_{CLK} with respect to the timings T₁ and T₂ can be accomplished by providing a delay with either one or both the delay units 35A and 35B. Thus, by varying the delay the specified minimum setup and hold times t_{SUmin} and t_{HOLDmin} can be verified.

In a preferred embodiment, a start timing is selected so that the unit to be tested is assumed to work properly and without failures. A functional test is then provided by comparing the received data with expected data. The timing is then varied in one or more steps until a predefined value, preferably the minimum setup or hold time t_{SUmin} and t_{HOLDmin}, and the test is repeated. The test might be abandoned in case a failure is detected. The test might also then be repeated into the opposite timing direction.

Instead of testing setup and hold time or in addition thereto, jitter can be applied by varying the delay over the time. Preferably, an arbitrary waveform generator controls the delay of one or more of the delay units 35, thus allowing to modulate the delay with any arbitrary waveform in order to induce the various types of jitter. This allows to check immunity of the receiver against jitter.

While the units to be tested 20 and 40 can be physically separated individual devices, they may also be physically arranged on one device. Further, the units 20 and 40 preferably have complementary function as e.g. the example of Fig.1 with deserializing and serializing.

It is clear that any other type of units 20 and 40 can be applied for the testing according to the present invention. Typical other examples are to provide the coupling unit 60 between the serial output of a serializer and the serial input of a deserializer (e.g. communication devices), between the output and the input of flip-flops, between the output and the input of computer buses like S-ATA, Hyper Transport, PCI Express, etc.

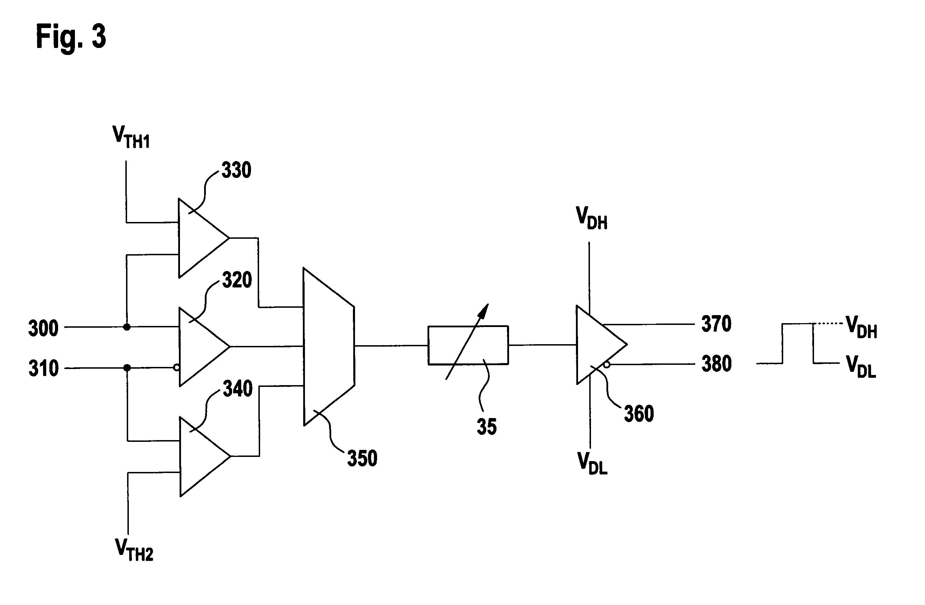

Figure 3 shows an embodiment for the signal path 30 allowing to apply single-ended signals as well as differential signals. An input line 300 (as provided e.g. form unit 20) is applied to inputs of a first comparator 320 and a second comparator 330. A second input line 310 is provided to an inverting input of the first comparator 320 and to an input of a third comparator 340. The second comparator 330 receives as second input a threshold voltage V_{TH1}, and the third comparator 340 receives as second input a threshold voltage V_{TH2}.

Outputs of the three comparators 320 to 340 are provided to a multiplexer 350 allowing to select and couple one of its input as its output. The output of the multiplexer 350 is provided to the delay unit 35, which can be a variable delay unit. The delayed output of the delay unit 35 is provided to the input of a driver 360 having a normal output 370 and an inverted output 380. Outputs 370 and 380, or only one of them, can then be applied to the unit 40. Control voltages V_{DH} and V_{DL} allow setting the output levels of the output signals on lines 370 and 380, as indicated by the levels of the example of a logic signal on the very right side in Figure 3.

In case that a differential signal, i.e. a normal signal and a complementary signal being complementary to the normal signal, is applied at the lines 300 and 310, the comparator 320 provides a combined single-ended signal by subtracting the normal and the complementary signal. The signal on line 300 is further compared with the threshold voltage V_{TH1}, and the comparator 330 provides a first logical level as long as the signal on line 300 exceeds the threshold voltage and a second logical level as long as the signal on line 300 is below the threshold voltage. Accordingly, the third comparator 340 provides a first logical level as long as the signal on line 310 exceeds the threshold voltage V_{TH2} and a second logical level as long as the signal on line 310 is below the threshold voltage. Applying the threshold voltages V_{TH}, in particular as variable voltages, allows to test the levels of the signals applied on either one of the lines 300 and 310.

Dependent whether one of the differential signals or their combined subtraction signal is to be tested as single-ended signal, the multiplexer 350 selects one of the outputs of the comparators 320 to 340. The delay unit 50 can then apply a delay to the selected signal. The driver 360 drives the signal received from the delay unit 35, whereby the output levels V_{DL} and V_{DH} can be set by applying the respective voltages to the driver 360. The output of the driver 360 is a differential signal with the signal on line 380 representing the inverted (complementary) signal on line 370.

In case that a single-ended signal is applied on either one of the input lines 300 or 310, the aforesaid applies accordingly, and the multiplexer 350 selects the adequate signal.

While the comparators 330 and 340 allow to test the signal levels at the input lines 300 and 310, the driver 360 allows to modify the output levels and the output lines 370 and 380. Accordingly, the comparators 330 and 340 allow testing the output levels of the output of the first unit to be tested 20, whereas the input level of the second unit under test 40 can be tested using the driver levels V_{DH} and V_{DL}.

## Claims

1. A coupling unit (60) adapted to be coupled between a first (20) and a second (40) unit to be tested, comprising:
one or more signal paths (30A), each adapted to provide a signal connection between an output (20A) of the first unit (20) to be tested and an input (40A) of the second unit (40) to be tested,
wherein at least one of the one or more signal paths (30A) comprises a delay unit (35A) adapted to provide a delay for a signal traveling on the signal path (30A).

2. The coupling unit of claim 1 or any one of the above claims, wherein at least one delay unit is a variable delay unit adapted to provide a variable delay for the signal traveling on the signal path.

3. The coupling unit of claim 1 or any one of the above claims, further comprising a control unit adapted for controlling the delay of one or more of the delay units, preferably by applying a control signal for modifying the delay over the time.

4. The coupling unit of claim 1 or any one of the above claims, wherein the second unit to be tested is substantially complementary in function to the first unit to be tested.

5. The coupling unit of claim 1 or any one of the above claims, comprising:
one or more data signal paths, each coupled between a data output of the first unit to be tested and a data input of the second unit to be tested, wherein the data output is adapted to provide a data signal and the data input is adapted to receive the provided data signal,
a clock signal path between a clock output of the first unit to be tested and a clock input of the second unit to be tested, wherein the clock output is adapted to provide a clocking signal to be received by the clock input for clocking one or more of the received data signals,
wherein at least one of the clock signal path and the one or more data signal paths comprises the delay unit.

6. The coupling unit of claim 1 or any one of the above claims, wherein the first and second units to be tested are comprised by either one device or each by a different device.

7. The coupling unit of claim 1 or any one of the above claims, wherein the coupling unit is a loop-back unit.

8. The coupling unit of claim 1 or any one of the above claims, wherein (Fig. 3) at least one signal path (30) is adapted to provide a differential signal connection for transmitting a differential signal having a normal signal (300) and a complementary signal (310) being complementary to the normal signal, the at least one signal path comprising:
a differential input unit (320, 330, 340, 350) adapted for receiving the differential signal and to provide as output a single-ended signal representing one of: the normal signal or a signal derived therefrom, the complementary signal or a signal derived therefrom, or a difference signal as the signal difference between the normal signal, or a signal derived therefrom, and the complementary signal, or a signal derived therefrom,
the delay unit (35) adapted for receiving the single-ended signal from the differential input unit, and
a differential output unit (360) adapted to receive the output signal of the delay unit (35), to derive therefrom a differential output signal (370, 380), and to provide the differential output signal to the second unit to be tested.

9. The coupling unit of claim 8 or any one of the above claims, comprising at least one of the following:
the differential input unit (320, 330, 340, 350) comprises at least one comparator (330, 340) adapted to provide as output a signal difference of one of the normal or the differential with respect to a respective threshold level (V_{TH1}, V_{TH2}),
the differential output unit is adapted to modify at least one level of the differential output signal.

10. A testing system adapted for testing operation of at least one of a first (20) and a second (40) unit to be tested, comprising:
a coupling unit (60) of claim 1 or any one of the above claims coupled between the first and the second unit to be tested, and
a signal analysis unit (50) adapted to analyze a response signal received from the second unit to be tested in response to a stimulus signal provided to the first unit to be tested.

11. The testing system of claim 10, further comprising a signal source (10) adapted to provide the stimulus signal to the first unit to be tested.

12. The testing system of claim 10 or any one of the above claims, further comprising a control unit adapted for controlling the delay of one or more of the delay units.

13. The testing system of claim 12, wherein the control unit adapted to execute at least one of the following:
• controlling the delay of one or more of the delay units in order to vary at least one of a setup time and a hold time (Fig. 2) of a digital data signal, wherein the setup time represents a time between a start of a valid data signal and a start of a valid clock signal, and the hold time represents a time between the start of the valid clock signal and an end of the valid data signal;
• controlling the delay of one or more of the delay units in order to induce jitter, preferably by applying a jitter signal to the delay.

14. A method for testing operation of at least one of a first and a second unit to be tested, comprising the steps of:
applying a stimulus signal to the first unit to be tested,
coupling one or more signal paths between the first and second units to be tested, each signal path providing a signal connection between an output of the first unit to be tested and an input of the second unit to be tested,
delaying a signal traveling on the signal path of at least one of the one or more signal paths,
receiving a response signal from the second unit to be tested in response to the stimulus signal,
analyzing the response signal.

15. The method of claim 14, wherein the step of analyzing the response signal comprises a step to comparing the response signal with an expected response signal representing a signal expected to receive in response to the stimulus signal.

16. The method of claim 14 or any one of the above claims, wherein the step of delaying comprises at least one of the steps:
• controlling the delay in order to vary at least one of a setup time and a hold time of a digital data signal, wherein the setup time represents a time between a start of a valid data signal and a start of a valid clock signal, and the hold time represents a time between the start of the valid clock signal and an end of the valid data signal;
• controlling the delay in order to induce jitter, preferably by applying a jitter signal to the delay.

17. A software program or product, preferably stored on a data carrier, for executing the method of claim 14 or any one of the above claims, when run on a data processing system such as a computer.
